# EUROPEAN PATENT APPLICATION

(11) **EP 3 258 749 A1**
(43) Date of publication of application: **20.12.2017**
(21) Application number: 17165188.8
(22) Date of filing: 06.04.2017
(51) Int. Cl.: H05K 1/02, H05K 3/40, H05K 1/18

(54) **ELECTRONIC CIRCUIT APPARATUS**

(30) Priority: 17.06.2016 JP 2016121038
(71) Applicant: Miyoshi Electronics Corporation, Miyoshi-shi, Hiroshima 728-8511 (JP)
(72) Inventor: MORI, Kazuhito, Kawanishi-shi, Hyogo 666-0024 (JP)
(74) Representative: Grünecker Patent- und Rechtsanwälte PartG mbB

(57) **Abstract**

There is provided an electronic circuit apparatus in which the heat generated at an electronic component can be transferred to a heat spreader efficiently. An electronic circuit apparatus (1) includes a dielectric substrate (10), an electronic component (61, 62), a heat spreader (15), and a conductive via (50). The conductive via (50) electrically and thermally connects the electronic component (61, 62) and the heat spreader (15). The conductive via (50) extends from the first surface (11) to at least an interior of the heat spreader (15) and is in surface-contact with the heat spreader (15).

## Description

This nonprovisional application is based on Japanese Patent Application No-2016-121038 filed on June 17, 2016, with the Japan Patent Office, the entire contents of which are hereby incorporated by reference.

### BACKGROUND OF THE INVENTION

### Field of the Invention

The present invention relates to an electronic circuit apparatus

### Description of the Background Art

An electronic circuit apparatus comprising a printed circuit board, an electronic component disposed on a front surface of the printed circuit board, and a heat spreader bonded to a back surface of the printed circuit board via solder is known (see Japanese Patent Laying-Open No. 5-95236). In the electronic circuit apparatus disclosed in Japanese Patent Laying-Open No. 5-95236, the heat generated at the electronic component is transferred to the heat spreader via a conductive via which penetrates between the front and back surfaces of the printed circuit board and the solder.

### SUMMARY OF THE INVENTION

However, in the electronic circuit apparatus described in Japanese Patent Laying-Open No. 5-95236, when the heat spreader is bonded to the printed circuit board using the solder, a void is generated in the solder. The void has a lower thermal conductivity than the solder. Since the solder includes the void, the heat generated at the electronic component is not easily transferred to the heat spreader.

The present invention has been made in view of the above issue, and an object thereof is to provide an electronic circuit apparatus allowing the heat generated at an electronic component to be efficiently transferred to a heat spreader.

The electronic circuit apparatus of the present embodiment comprises a dielectric substrate, an electronic component, a heat spreader, and a conductive via. The dielectric substrate has a first surface and a second surface opposite to the first surface. The electronic component is mounted on the first surface. The heat spreader is bonded to the second surface via a first bonding member. The conductive via electrically and thermally connects the electronic component and the heat spreader. The conductive via extends from the first surface to at least an interior of the heat spreader and is in surface-contact with the heat spreader.

The foregoing and other objects, features, aspects and advantages of the present invention will become more apparent from the following detailed description of the present invention when taken in conjunction with the accompanying drawings

### BRIEF DESCRIPTION OF THE DRAWINGS

Fig 1 is a schematic plan view of an electronic circuit apparatus according to a first embodiment of the present invention,
Fig 2 is a schematic cross section of the electronic circuit apparatus according to the first embodiment of the present invention taken along a line 11-11 shown in Fig. 1.
Fig. 3 is a schematic partial enlarged cross section of the electronic circuit apparatus according to the first and third embodiments of the present invention at a region III shown in Figs. 2 and 12.
Fig 4 shows a flowchart of a method for producing the electronic circuit apparatus according to the first embodiment of the present invention.
Fig. 5 shows a flowchart of a process for forming a conductive via in the method for producing the electronic circuit apparatus according to the first embodiment of the present invention.
Fig. 6 is a schematic partial enlarged cross section of an electronic circuit apparatus according to an exemplary variation of the first embodiment of the present invention.
Fig. 7 is a schematic plan view of an electronic circuit apparatus according to a second embodiment of the present invention.
Fig. 8 is a schematic cross section of the electronic circuit apparatus according to the second embodiment of the present invention taken along a line VIII-VIII shown in Fig. 7.
Fig. 9 is a schematic partial enlarged cross section of the electronic circuit apparatus according to the second embodiment of the present invention at a region IX shown in Fig. 8.
Fig. 10 is a schematic partial enlarged cross section of an electronic circuit apparatus according to an exemplary variation of the second embodiment of the present invention.
Fig. 11 is a schematic plan view of an electronic circuit apparatus according to a third embodiment of the present invention.
Fig 12 is a schematic cross section of the electronic circuit apparatus according to the third embodiment of the present invention taken along a line XII-XII shown in Fig. 11.
Fig. 13 is a schematic partial enlarged cross section of the electronic circuit apparatus according to the third embodiment of the present invention at a region Xlll shown in Fig. 12.

### DESCRIPTION OF THE PREFERRED EMBODIMENTS

Hereinafter, embodiments of the present invention will be described. Note that identical components are identically denoted and will not be described repeatedly.

### First Embodiment

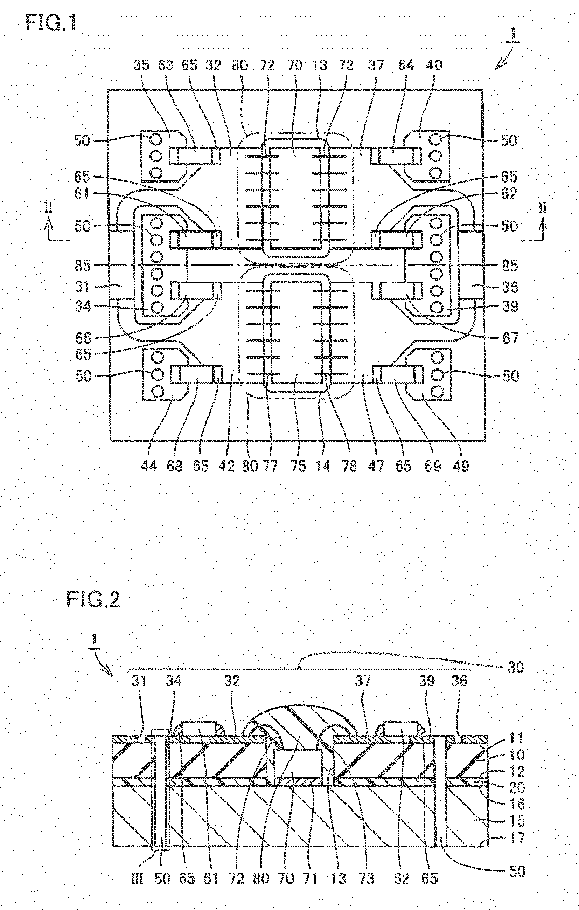

With reference to Fig. 1 to Fig. 3, an electronic circuit apparatus 1 according to the first embodiment will be described. Electronic circuit apparatus 1 of the present embodiment mainly comprises a dielectric substrate 10, an electronic component (61, 62, 63, 64, 66, 67, 68, 69), a heat spreader 15, and a conductive via 50. Electronic circuit apparatus 1 of the present embodiment comprises a semiconductor chip (70, 75) and a sealing member 80, as desired. Electronic circuit apparatus 1 of the present embodiment may be a semiconductor module comprising semiconductor chip (70, 75).

Dielectric substrate 10 has a first surface 11 and a second surface 12 opposite to first surface 11. Although dielectric substrate 10 is not limited to any particular substrate, it may be a glass epoxy substrate such as an FR-5 substrate or an alumina substrate for example.

Dielectric substrate 10 includes a conductive pattern (31, 32, 34, 35, 36, 37, 39, 40, 42, 44, 47, 49). Conductive pattern (31, 32, 34, 35, 36, 37, 39, 40, 42, 44, 47, 49) is provided on first surface 11 of dielectric substrate 10. Such conductive patterns (31, 32, 34, 35, 36, 37, 39, 40, 42, 44, 47, 49) may be disposed symmetrically with respect to a line 85. Although conductive pattern (31, 32, 34, 35, 36, 37, 39, 40, 42, 44, 47, 49) is not limited to any particular material, it may be composed of a material which mainly contains copper (Cu) or aluminum (Al) for example. Conductive pattern (31, 32, 34, 35, 36, 37, 39, 40, 42, 44, 47, 49) may be formed by plating a conductive material on first surface 11 of dielectric substrate 10.

Conductive pattern (31, 32, 34, 35, 36, 37, 39, 40, 42, 44, 47, 49) includes an input terminal 31, a first input wiring 32 connected to input terminal 31, an output terminal 36, and a first output wiring 37 connected to output terminal 36. In a plan view of first surface 11 of dielectric substrate 10, a first cavity portion 13 is located between first input wiring 32 and first output wiring 37. Conductive pattern (31, 32, 34, 35, 36, 37, 39, 40, 42, 44, 47, 49) may further include a second input wiring 42 connected to input terminal 31 and a second output wiring 47 connected to output terminal 36. In the plan view of first surface 11 of dielectric substrate 10, a second cavity portion 14 may be located between second input wiring 42 and second output wiring 47.

Conductive pattern (31, 32, 34, 35, 36, 37, 39, 40, 42, 44, 47, 49) may further include a first ground pad 34, a second ground pad 35, a third ground pad 39, and a fourth ground pad 40. In the plan view of first surface 11 of dielectric substrate 10, first ground pad 34, second ground pad 35, third ground pad 39, and fourth ground pad 40 may be disposed as follows: First ground pad 34 may be adjacent to input terminal 31, first input wiring 32, and second input wiring 42. Second ground pad 35 may be disposed on first surface 11 such that first input wiring 32 is sandwiched by first ground pad 34 and second ground pad 35. Third ground pad 39 may be adjacent to output terminal 36, first output wiring 37, and second output wiring 47. Fourth ground pad 40 may be disposed on first surface 11 such that first output wiring 37 is sandwiched by third ground pad 39 and fourth ground pad 40.

Conductive pattern (31, 32, 34, 35, 36, 37, 39, 40, 42, 44, 47, 49) may further include a fifth ground pad 44 and a sixth ground pad 49. In the plan view of first surface 11 of dielectric substrate 10, fifth ground pad 44 and sixth ground pad 49 may be disposed as follows: Fifth ground pad 44 may be disposed on first surface 11 such that second input wiring 42 is sandwiched by first ground pad 34 and fifth ground pad 44. Sixth ground pad 49 may be disposed on first surface 11 such that second output wiring 47 is sandwiched by third ground pad 39 and sixth ground pad 49.

Electronic component (61, 62, 63, 64, 66, 67, 68, 69) is mounted on first surface 11 using a third bonding member 65. Specifically, electronic component (61, 62, 63, 64, 66, 67, 68, 69) is bonded to conductive pattern (31, 32, 34, 35, 36, 37, 39, 40, 42, 44, 47, 49) provided on first surface 11 using third bonding member 65. Although electronic component (61, 62, 63, 64, 66, 67, 68, 69) is not limited to any particular component, it may be a chip capacitor or a chip resistor, for example. Electronic component (61, 62, 63, 64, 66, 67, 68, 69) may be mutually identical electronic components or mutually different electronic components. Electronic components (61, 62, 63, 64, 66, 67, 68, 69) may be disposed symmetrically with respect to line 85. Third bonding member 65 may be a lead-free solder such as SAC305, for example.

One or more electronic components (61, 62, 63, 64, 66, 67, 68, 69) may be mounted on first surface 11 of dielectric substrate 10. In the present embodiment, eight electronic components (61, 62, 63, 64, 66, 67, 68, 69) are mounted on first surface 11 of dielectric substrate 10. A first electronic component 61 is bonded to first input wiring 32 and first ground pad 34. A second electronic component 62 is bonded to first output wiring 37 and third ground pad 39. A third electronic component 63 is bonded to first input wiring 32 and second ground pad 35. A fourth electronic component 64 is bonded to first output wiring 37 and fourth ground pad 40 A fifth electronic component 66 is bonded to second input wiring 42 and first ground pad 34. A sixth electronic component 67 is bonded to second output wiring 47 and third ground pad 39. A seventh electronic component 68 is bonded to second input wiring 42 and fifth ground pad 44. An eighth electronic component 69 is bonded to second output wiring 47 and sixth ground pad 49.

Heat spreader 15 dissipates outside electronic circuit apparatus 1 heat generated at electronic component (61, 62, 63, 64, 66, 67, 68, 69). Heat spreader 15 has a larger thermal conductivity than dielectric substrate 10. Heat spreader 15 preferably has a thermal conductivity of 5.0 W/(m·K) or more, more preferably 10.0 W/(m·K) or more. Heat spreader 15 is composed of a material such as copper (Cu) or aluminum (Al), for example. Heat spreader 15 may be bonded using a fourth bonding member (not shown) such as grease to a heat radiating member (not shown) or a casing (not shown) which accommodates electronic circuit apparatus 1 therein. Heat spreader 15 has a third surface 16 and a fourth surface 17 opposite to third surface 16. Third surface 16 of heat spreader 15 faces second surface 12 of dielectric substrate 10. Fourth surface 17 of heat spreader 15 is a surface facing away from dielectric substrate 10.

Heat spreader 15 is bonded to second surface 12 of dielectric substrate 10 via a first bonding member 20. Heat spreader 15 has third surface 16 bonded to second surface 12 of dielectric substrate 10 via first bonding member 20. First bonding member 20 may be composed of a reinforced plastic material such as epoxy resin reinforced by glass cloth. First bonding member 20 including the reinforced plastic material may have a softening temperature higher than the melting point of third bonding member 65.

Dielectric substrate 10 may have a cavity portion (13, 14) extending from first surface 11 to third surface 16 of heat spreader 15. In the plan view of first surface 11 of dielectric substrate 10, heat spreader 15 is exposed from dielectric substrate 10 and first bonding member 20 in cavity portion (13, 14). One or more cavity portions (13, 14) may be provided. In the present embodiment, dielectric substrate 10 has a first cavity portion 13 and a second cavity portion 14.

Semiconductor chip (70, 75) is disposed in cavity portion (13, 14). Disposing semiconductor chip (70, 75) in cavity portion (13, 14) includes not only that any semiconductor chip (70, 75) is disposed in cavity portion (13, 14), but also that only some semiconductor chip (70, 75) is disposed in cavity portion (13, 14). One or more semiconductor chips (70, 75) may be provided. In the present embodiment, two semiconductor chips (70, 75) are disposed in cavity portions (13, 14). A first semiconductor chip 70 is disposed in first cavity portion 13. A second semiconductor chip 75 is disposed in second cavity portion 14. Semiconductor chips (70, 75) may be disposed symmetrically with respect to line 85.

Although semiconductor chip (70, 75) is not limited to any particular semiconductor chip, it may be a high frequency semiconductor device or a power semiconductor device, for example. Specifically, semiconductor chip (70, 75) may be an insulating gated bipolar transistor (IGBT), a metal oxide semiconductor field effect transistor (MOSFET), a gate turnoff (GTO) thyristor, or a diode. Second semiconductor chip 75 may be identical to or different from first semiconductor chip 70.

Semiconductor chip (70, 75) is bonded to heat spreader 15 via a second bonding member 71 in cavity portion (13, 14). Semiconductor chip (70, 75) is mechanically and thermally connected to heat spreader 15 via second bonding member 71. Semiconductor chip (70, 75) may electrically be connected to heat spreader 15 via second bonding member 71. Second bonding member 71 may be composed of a resin which contains a metal filler such as a copper (Cu) filler, or a sintered metal particle compact such as a silver nanoparticle sintered compact, for example. Second bonding member 71 preferably has a thermal conductivity of 1.0 W/(m·K) or more, more preferably 10.0 W/(m·K) or more. Second bonding member 71 may have a melting point or a softening temperature higher than the melting point of third bonding member 65.

Semiconductor chip (70, 75) is electrically connected to electronic component (61, 62, 63, 64, 66, 67, 68, 69). Semiconductor chip (70, 75) is electrically connected to electronic component (61, 62, 63, 64, 66, 67, 68, 69) via conductive pattern (32, 37, 42, 47) provided on first surface 11, and a conductive wire (72, 73, 77, 78). Specifically, first semiconductor chip 70 is electrically connected to first electronic component 61 and third electronic component 63 via a first conductive wire 72 and first input wiring 32. First semiconductor chip 70 is electrically connected to second electronic component 62 and fourth electronic component 64 via a second conductive wire 73 and first output wiring 37. Second semiconductor chip 75 is electrically connected to fifth electronic component 66 and seventh electronic component 68 via a third conductive wire 77 and second input wiring 42. Second semiconductor chip 75 is electrically connected to sixth electronic component 67 and eighth electronic component 69 via a fourth conductive wire 78 and second output wiring 47.

Sealing member 80 seals semiconductor chip (70, 75). Sealing member 80 may cover semiconductor chip (70, 75) entirely. Sealing member 80 may further seal conductive wire (72, 73, 77, 78). Sealing member 80 may further cover conductive wire (72, 73, 77, 78) partially or entirety. Sealing member 80 fills cavity portion (13, 14). Sealing member 80 may be composed of a resin material such as epoxy resin.

Conductive via 50 electrically and thermally connects electronic component (61, 62, 63, 64, 66, 67, 68, 69) and heat spreader 15. Specifically, conductive via 50 connects a ground pad (34, 35, 39, 40, 44, 49) to which electronic component (61, 62, 63, 64, 66, 67, 68, 69) is bonded, and heat spreader 15. Electronic component (61, 62, 63, 64, 66, 67, 68, 69) and heat spreader 15 are electrically and thermally connected to each other via conductive via 50 and ground pad (34, 35, 39, 40, 44, 49).

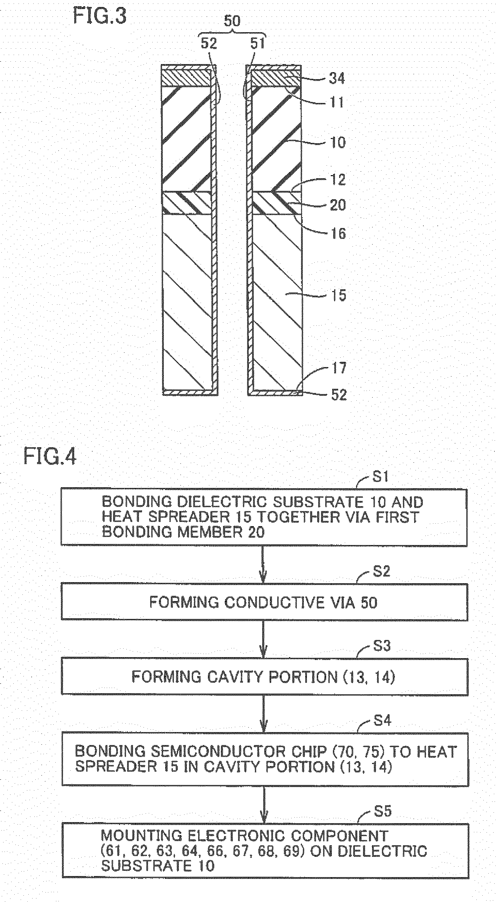

Conductive via 50 extends from first surface 11 of dielectric substrate 10 to at least an interior of heat spreader 15. As shown in Fig. 1 and Fig. 3, conductive via 50 may penetrate dielectric substrate 10 and heat spreader 15. Conductive via 50 may penetrate between first surface 11 of dielectric substrate 10 and fourth surface 17 of heat spreader 15. Conductive via 50 is in surface-contact with heat spreader 15. Conductive via 50 is in surface-contact with heat spreader 15 at a side surface of conductive via 50.

Conductive via 50 includes a hole 51 and a conductive layer 52 provided on a surface of hole 51. Hole 51 extends from first surface 11 of dielectric substrate 10 to at least an interior of heat spreader 15. Hole 51 may penetrate dielectric substrate 10 and heat spreader 15. Hole 51 may penetrate between first surface 11 of dielectric substrate 10 and fourth surface 17 of heat spreader 15. Conductive layer 52 is provided on a surface of hole 51. Specifically, conductive layer 52 is provided on a side surface of hole 51.

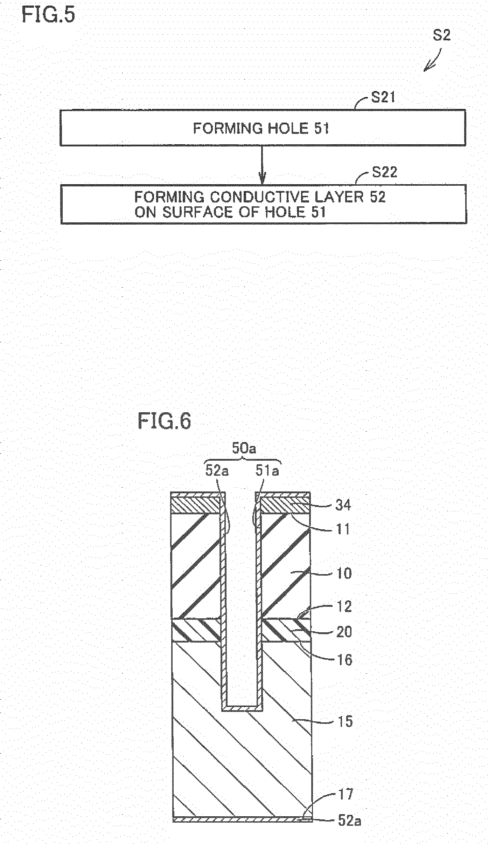

While in the exemplary variation of the present embodiment shown in Fig. 6 conductive via 50a penetrates dielectric substrate 10, it may not penetrate heat spreader 15. While conductive via 50a penetrates between first surface 11 and second surface 12 of dielectric substrate 10, it may not extend to fourth surface 17 of heat spreader 15. Conductive via 50a is in surface-contact with heat spreader 15 on side and bottom surfaces of conductive via 50a.

Conductive via 50a includes a hole 51 a and a conductive layer 52a provided on a surface of hole 51a While hole 51a penetrates dielectric substrate 10, it may not penetrate heat spreader 15. While hole 51 a penetrates between first surface 11 and second surface 12 of dielectric substrate 10, it may not extend to fourth surface 17 of heat spreader 15. Conductive layer 52a is provided on a surface of hole 51a. Specifically, conductive layer 52a is provided on side and bottom surfaces of hole 51 a.

With reference to Fig. 3, conductive layer 52 may be further provided on a surface of conductive pattern (31, 32, 34, 35, 36, 37, 39, 40, 42, 44, 47, 49) on a side opposite to dielectric substrate 10. This increases a contact area of conductive via 50 and conductive pattern (31, 32, 34, 35, 36, 37, 39, 40, 42, 44, 47, 49). The heat generated at electronic component (61, 62, 63, 64, 66, 67, 68, 69) can be transferred to heat spreader 15 more efficiently. Conductive layer 52 may be further provided on fourth surface 17 of heat spreader 15. This increases a contact area of conductive via 50 and heat spreader 15. The heat generated at electronic component (61, 62, 63, 64, 66, 67, 68, 69) can be transferred to heat spreader 15 more efficiently

With reference to Fig. 4, a method for producing electronic circuit apparatus 1 of the present embodiment will be described.

The method for producing electronic circuit apparatus 1 of the present embodiment comprises bonding dielectric substrate 10 provided with conductive pattern (31, 32, 34, 35, 36, 37, 39, 40, 42, 44, 47, 49), and heat spreader 15 together via first bonding member 20 (S1). A case where first bonding member 20 is composed of a reinforced plastic material is referred to by way of example to specifically describe the bonding step (S1). First bonding member 20 is disposed between dielectric substrate 10 and heat spreader 15. Dielectric substrate 10, first bonding member 20, and heat spreader 15 are pressed while heat is applied thereto. Thus, dielectric substrate 10 and heat spreader 15 are bonded together via first bonding member 20. After the bonding step (S1), first bonding member 20 composed of the reinforced plastic material substantially does not include void.

The method for producing electronic circuit apparatus 1 of the present embodiment comprises forming conductive via 50 (S2). With reference to Fig. 5, forming conductive via 50 (S2) includes forming hole 51 (S21) and forming conductive layer 52 on a surface of hole 51 (S22). Forming hole 51 (S21) may also include using a drill to form hole 51 in dielectric substrate 10 and heat spreader 15 bonded via first bonding member 20, for example. Hole 51 may be formed to penetrate dielectric substrate 10 and heat spreader 15. Hole 51 may be formed without penetrating heat spreader 15, while penetrating dielectric substrate 10. Forming conductive layer 52 on a surface of hole 51 (S22) may also include forming conductive layer 52 on a surface of hole 51 for example by plating. Forming conductive layer 52 on a surface of hole 51 (S22) may also include forming conductive layer 52 on a surface of conductive pattern (31, 32, 34, 35, 36, 37, 39, 40, 42, 44, 47, 49) on a side opposite to dielectric substrate 10. Forming conductive layer 52 on a surface of hole 51 (S22) may also include forming conductive layer 52 on fourth surface 17 of heat spreader 15.

The method for producing electronic circuit apparatus 1 of the present embodiment comprises forming cavity portion (13, 14) (S3). Forming cavity portion (13, 14) (S3) may also include removing dielectric substrate 10 and first bonding member 20. Specifically, forming cavity portion (13, 14) (S3) may also include polishing or grinding dielectric substrate 10 and first bonding member 20. By removing dielectric substrate 10 and first bonding member 20, heat spreader 15 is exposed in cavity portion (13, 14) from dielectric substrate 10 and first bonding member 20. In the method for producing electronic circuit apparatus 1 of the present embodiment, cavity portion (13, 14) is formed (S3) after conductive layer 52 is formed on a surface of hole 51 (S22). However, conductive layer 52 may be formed on a surface of hole 51 (S22) after cavity portion (13, 14) is formed (S3).

The method for producing electronic circuit apparatus 1 of the present embodiment comprises bonding semiconductor chip (70, 75) to heat spreader 1 in cavity portion (13, 14) (S4). Specifically, semiconductor chip (70, 75) is bonded to heat spreader 15 using second bonding member 71.

The method for producing electronic circuit apparatus 1 of the present embodiment comprises mounting electronic component (61, 62, 63, 64, 66, 67, 68, 69) on dielectric substrate 10 (S5). Specifically, electronic component (61, 62, 63, 64, 66, 67, 68, 69) is mounted on first surface 11 of dielectric substrate 10 using third bonding member 65. More specifically, electronic component (61, 62, 63, 64, 66, 67, 68, 69) is bonded by using third bonding member 65 to conductive pattern (31, 32, 34, 35, 36, 37, 39, 40, 42, 44, 47, 49) provided on first surface 11 of dielectric substrate 10.

In the method for producing electronic circuit apparatus 1 oaf the present embodiment, after semiconductor chip (70, 75) is bonded to heat spreader 15 in cavity portion (13, 14) (S4), electronic component (61, 62, 63, 64, 66, 67, 68, 69) is mounted on dielectric substrate 10(S5). However, semiconductor chip (70, 75) may be bonded to heat spreader 15 in cavity portion (13, 14) (S4) after electronic component (61, 62, 63, 64, 66, 67, 68, 69) is mounted on dielectric substrate 10 (S5).

A function and effect of electronic circuit apparatus 1 of the present embodiment and an exemplary variation thereof will be described.

Electronic circuit apparatus 1 of the present embodiment comprises dielectric substrate 10, electronic component (61, 62, 63, 64, 66, 67, 68, 69), heat spreader 15, and conductive via 50. Electronic circuit apparatus 1 of the exemplary variation of the present embodiment comprises dielectric substrate 10, electronic component (61, 62, 63, 64, 66, 67, 68, 69), heat spreader 15, and conductive via 50a. Dielectric substrate 10 has first surface 11 and second surface 12 opposite to first surface 11. Electronic component (61, 62, 63, 64, 66, 67, 68, 69) is mounted on first surface 11 of dielectric substrate 10. Heat spreader 15 is bonded to second surface 12 of dielectric substrate 10 via first bonding member 20. Conductive via 50, 50a electrically and thermally connects electronic component (61, 62, 63, 64, 66, 67, 68, 69) and heat spreader 15. Conductive via 50, 50a extends from first surface 1 to at least an interior of heat spreader 15 and are in surface-contact with heat spreader 15.

In electronic circuit apparatus 1 of the present embodiment and the exemplary variation, conductive via 50, 50a extends from first surface 11 to at least an interior of heat spreader 15 and are in surface-contact with heat spreader 15, and accordingly, a thermal resistance between conductive via 50, 50a and heat spreader 15 can be reduced There is no void in a path transferring to heat spreader 15 the heat generated at electronic component (61, 62, 63, 64, 66, 67, 68, 69). Electronic circuit apparatus 1 of the present embodiment and the exemplary variation can efficiently transfer to heat spreader 15 the heat generated at electronic component (61, 62, 63, 64, 66, 67, 68, 69).

In electronic circuit apparatus 1 of the present embodiment and the exemplary variation, conductive via 50, 50a extends from first surface 11 to at least an interior of heat spreader 15 and are in surface-contact with heat spreader 15, and accordingly, an electrical resistance between electronic component (61, 62, 63, 64, 66, 67, 68, 69) and heat spreader 15 can be reduced. Accordingly, an amount of heat generated in electronic circuit apparatus 1 can be reduced. Electronic circuit apparatus 1 of the present embodiment and the exemplary variation has an improved electrical efficiency. In electronic circuit apparatus 1 of the present embodiment and the exemplary variation, an operation of semiconductor chip (70, 75) can be stabilized.

On the other hand, in an electronic circuit apparatus of a comparative example, heat spreader 15 is bonded to dielectric substrate 10 using solder, and a conductive via is formed only in dielectric substrate 10. In the electronic circuit apparatus of the comparative example, when heat spreader 15 is bonded to dielectric substrate 10 using solder, a void is generated in the solder. The void increases thermal resistance and electrical resistance between electronic component (61, 62, 63, 64, 66, 67, 68, 69) and heat spreader 15. Thus in the electronic circuit apparatus of the comparative example it is difficult to efficiently transfer to heat spreader 15 the heat generated at electronic component (61, 62, 63, 64, 66, 67, 68, 69). Accordingly, an amount of heat generated in the electronic circuit apparatus of the comparative example increases. The electronic circuit apparatus of the comparative example has low electric efficiency. In the electronic circuit apparatus of the comparative example, semiconductor chip (70, 75) operates unstably

In electronic circuit apparatus 1 of the present embodiment, conductive via 50 may penetrate heat spreader 15. As conductive via 50 penetrates heat spreader 15, conductive via 50 is in surface-contact with heat spreader 15 over a larger area. Electronic circuit apparatus 1 of the present embodiment can further efficiently transfer to heat spreader 15 the heat generated at electronic component (61, 62, 63, 64, 66, 67, 68, 69).

In electronic circuit apparatus 1 of the present embodiment and the exemplary variation, first bonding member 20 may include a reinforced plastic material. Specifically, electronic component (61, 62, 63, 64, 66, 67, 68, 69) may be mounted on first surface 11 of dielectric substrate 10 using third bonding member 65. First bonding member 20 has a softening temperature higher than the melting point of third bonding member 65. Accordingly, when electronic component (61, 62, 63, 64, 66, 67, 68, 69) is mounted on first surface 11 of dielectric substrate 10 using third bonding member 65, a stable bonding between heat spreader 15 and dielectric substrate 10 via first bonding member 20 can be maintained.

Electronic circuit apparatus 1 of the present embodiment and the exemplary variation may further comprise semiconductor chip (70, 75) electrically connected to electronic component (61, 62, 63, 64, 66, 67, 68, 69). Dielectric substrate 10 may have cavity portion (13, 14) extending from first surface 11 to heat spreader 15. Semiconductor chip (70, 75) may be bonded to heat spreader 15 via second bonding member 71 in cavity portion (13, 14). Since semiconductor chip (70, 75) is bonded to heat spreader 15 via second bonding member 71, the heat generated at semiconductor chip (70, 75) can be efficiently transferred to heat spreader 15

Electronic circuit apparatus 1 of the present embodiment and the exemplary variation may further comprise sealing member 80 which seals semiconductor chip (70, 75). Sealing member 80 protects semiconductor chip (70, 75) from mechanical stress and moisture. Sealing member 80 can suppress generation and growth of a crack in second bonding member 71 when electronic circuit apparatus 1 operates. Sealing member 80 can increase the lifetime of electronic circuit apparatus 1.

### Second Embodiment

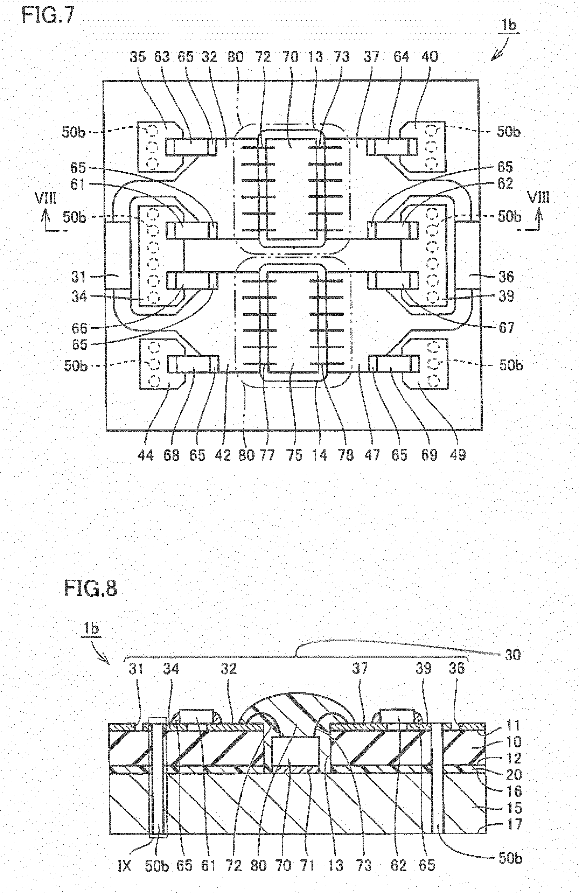

With reference to Fig. 7 to Fig. 9, an electronic circuit apparatus 1b according to a second embodiment will be described. While electronic circuit apparatus 1b of the present embodiment has basically the same configuration as electronic circuit apparatus 1 of the first embodiment, the former differs from the latter mainly as follows:
In electronic circuit apparatus 1b of the present embodiment, a conductive via 50b may include a filling member 53. Filling member 53 is introduced into hole 51 which configures conductive via 50b. Filling member 53 may have a thermal conductivity equal to that of dielectric substrate 10 or larger than that of dielectric substrate 10. Filling member 53 may be composed of a resin which contains a filler such as a copper (Cu) filler, or a resin which does not contain a filler, for example.

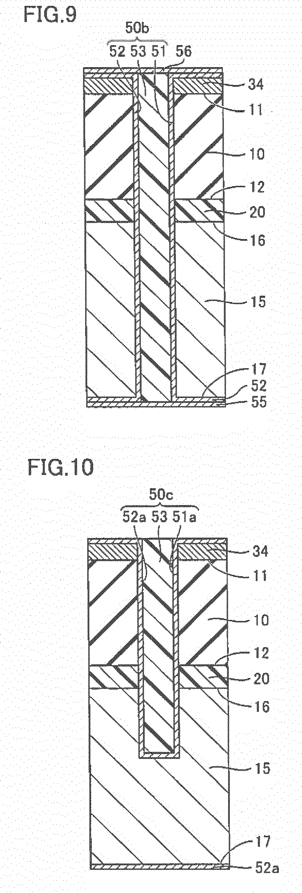

In the exemplary variation of the present embodiment shown in Fig. 10, while a conductive via 50c penetrates dielectric substrate 10, it may not penetrate heat spreader 15. While conductive via 50c penetrates between first surface 11 and second surface 12 of dielectric substrate 10, it may not extend to fourth surface 17 of heat spreader 15. Conductive via 50c is in surface-contact with heat spreader 15 on side and bottom surfaces of conductive via 50c.

Conductive via 50c includes hole 51 a, conductive layer 52a provided on a surface of hole 51a, and filling member 53. Filling member 53 is introduced into hole 51a which configures conductive via 50c. Conductive via 50c of the exemplary variation of the present embodiment is equivalent to a conductive via in which filling member 53 is introduced into hole 51a of the exemplary variation of the first embodiment (see Fig. 6). While hole 51a penetrates dielectric substrate 10, it may not penetrate heat spreader 15. While hole 51a a penetrates between first surface 11 and second surface 12 of dielectric substrate 10, it may not extend to fourth surface 17 of heat spreader 15. Conductive layer 52a is provided on a surface of hole 51a. Specifically, conductive layer 52a is provided on side and bottom surfaces of hole 51a.

With reference to Fig. 9, electronic circuit apparatus 1b of the present embodiment may further comprise a first cover part 55 that covers a surface of filling member 53 on the side of heat spreader 15. First cover part 55 may further cover fourth surface 17 of heat spreader 15. First cover part 55 may further cover conductive layer 52 provided on fourth surface 17 of heat spreader 15. Electronic circuit apparatus 1b of the present embodiment may further comprise a second cover part 56 which covers a surface of filling member 53 on the side of dielectric substrate 10. Second cover part 56 may further cover conductive pattern (31, 32, 34, 35, 36, 37, 39, 40, 42, 44, 47, 49). Second cover part 56 may further cover the conductive layer 52 provided on conductive pattern (31, 32, 34, 35, 36, 37, 39, 40, 42, 44, 47, 49) First cover part 55 and second cover part 56 may be formed by plating.

A function and effect of electronic circuit apparatus 1b of the present embodiment and an exemplary variation thereof will be described. Basically, electronic circuit apparatus 1 of the present embodiment and the exemplary variation has an effect of electronic circuit apparatus 1 of the first embodiment and an exemplary variation thereof, and in addition thereto, the following effects:

In electronic circuit apparatus 1b of the present embodiment, conductive via 50b may include filling member 53. In electronic circuit apparatus 1b of the exemplary variation of the present embodiment, conductive via 50c may include filling member 53. Filling member 53 may have a thermal conductivity equal to or greater than the thermal conductivity of dielectric substrate 10. Filling member 53 can reduce thermal resistance between conductive via 50b, 50c and heat spreader 15. Electronic circuit apparatus 1b of the present embodiment and the exemplary variation can transfer the heat generated at electronic component (61, 62, 63, 64, 66, 67, 68, 69) to heat spreader 15 more efficiently than electronic circuit apparatus 1 of the first embodiment and its exemplary variation.

Electronic circuit apparatus 1b of the present embodiment may further comprise a cover part (first cover part 55) which covers a surface of filling member 53 on the side of heat spreader 15. When heat spreader 15 is bonded using a fourth bonding member (not shown) such as grease to a heat radiating member (not shown) or a casing (not shown) which accommodates electronic circuit apparatus 1b therein, the fourth bonding member can be prevented from entering conductive via 50b.

### Third Embodiment

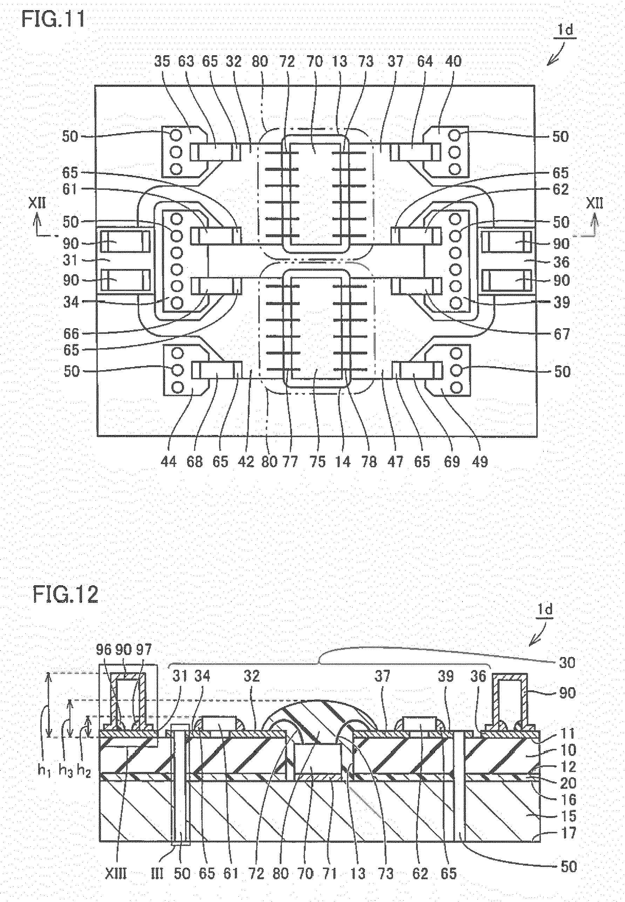

With reference to Fig. 11 to Fig. 13, an electronic circuit apparatus 1d according to a third embodiment will be described. While electronic circuit apparatus 1d of the present embodiment has basically the same configuration as electronic circuit apparatus 1 of the first embodiment, the former differs from the latter mainly as follows:

Electronic circuit apparatus 1d of the present embodiment may further comprise a connection terminal 90 electrically connected to electronic component (61, 62, 63, 64, 66, 67, 68, 69). A first height h₁ of connection terminal 90 from first surface 11 of dielectric substrate 10 is larger than a second height h₂ of electronic component (61, 62, 63, 64, 66, 67, 68, 69) from first surface 11 of dielectric substrate 10. When semiconductor chip (70, 75) is sealed by sealing member 80, first height h₁ of connection terminal 90 from first surface 11 of dielectric substrate 10 is larger than second height h₂ of electronic component (61, 62, 63, 64, 66, 67, 68, 69) from first surface 11 of dielectric substrate 10 and a third height h₃ of sealing member 80 from first surface 11 of dielectric substrate 10.

Connection terminal 90 is provided on input terminal 31 and output terminal 36. Specifically, first electronic component 61 and third electronic component 63 are electrically connected via input terminal 31 and first input wiring 32 to connection terminal 90 provided on input terminal 31. Second electronic component 62 and fourth electronic component 64 are electrically connected via output terminal 36 and first output wiring 37 to connection terminal 90 provided on output terminal 36. Fifth electronic component 66 and seventh electronic component 68 are electrically connected via input terminal 31 and second input wiring 42 to connection terminal 90 provided on input terminal 31. Sixth electronic component 67 and eighth electronic component 69 are electrically connected via output terminal 36 and second output wiring 47 to connection terminal 90 provided on output terminal 36.

One or more connection terminals 90 may be provided on input terminal 31. In the present embodiment, two connection terminals 90 are provided on input terminal 31. One or more connection terminals 90 may be provided on output terminal 36. In the present embodiment, two connection terminals 90 are provided on output terminal 36.

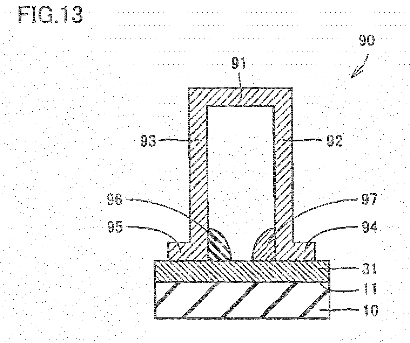

With reference to Fig. 13, connection terminals 90 each includes a top portion 91, a pair of legs (92, 93), and a pair of bottom portions (94, 95). When electronic circuit apparatus 1d is surface-mounted on a circuit board (not shown), top portion 91 is electrically connected to the circuit board (not shown). First leg 92 extends from one end of top portion 91 toward first surface 11 of dielectric substrate 10. Second leg 93 extends from the other end of top portion 91 toward first surface 11 of dielectric substrate 10. First bottom portion 94 extends along first surface 11 from an end of first leg 92 opposite to top portion 91. Second bottom portion 95 extends along first surface 11 from an end of second leg 93 opposite to top portion 91. First and second bottom portions 94 and 95 extend in opposite directions, respectively. Connection terminal 90 may be formed by bending a conductive plate. The shape of connection terminal 90 is not limited to the shape shown in Figs. 11-13. Connection terminal 90 is only required to be configured such that electronic circuit apparatus 1d can be surface-mounted on a circuit board (not shown).

Connection terminal 90 is electrically connected to input terminal 31 and output terminal 36 and also mechanically bonded thereto. Specifically, connection terminal 90 is mechanically bonded to input terminal 31 and output terminal 36 using an electrically insulating adhesive 96. Connection terminal 90 is electrically connected to input terminal 31 and output terminal 36 using solder 97. Connection terminal 90 may be electrically connected to input terminal 31 and output terminal 36 and also mechanically bonded thereto using solder or an electrically conductive adhesive.

A function and effect of electronic circuit apparatus 1d of the present embodiment will be described. Basically, electronic circuit apparatus I d of the present embodiment has an effect of electronic circuit apparatus 1 of the first embodiment, and in addition thereto, the following effects:
Electronic circuit apparatus 1d of the present embodiment may further comprise connection terminal 90 electrically connected to electronic component (61, 62, 63, 64, 66, 67, 68, 69). First height h₁ of connection terminal 90 from first surface 11 is larger than second height h₂ of electronic component (61, 62, 63, 64, 66, 67, 68, 69) from first surface 11. Connection terminal 90 allows electronic circuit apparatus 1 d to be surface-mounted on a circuit board (not shown) without receiving a mechanical interference of electronic component (61, 62, 63, 64, 66, 67, 68, 69).
Electronic circuit apparatus 1d of the present embodiment may further comprise connection terminal 90 electrically connected to electronic component (61, 62, 63, 64, 66, 67, 68, 69). First height h₁ of connection terminal 90 from first surface 11 is larger than second height h₂ of electronic component (61, 62, 63, 64, 66, 67, 68, 69) from first surface 11 and third height h₃of sealing member 80 from first surface 11. Connection terminal 90 allows electronic circuit apparatus 1d to be surface-mounted on a circuit board (not shown) without receiving a mechanical interference of electronic component (61, 62, 63, 64, 66, 67, 68, 69) and sealing member 80.

While the present invention has been described in embodiments, it should be understood that the embodiments disclosed herein are illustrative and non-restrictive in any respect. As long as there is no contradiction, at least two of the first to third embodiments and their exemplary variations maybe combined together. The scope of the present invention is defined by the terms of the claims, and is intended to include any modifications within the meaning and scope equivalent to the terms of the claims.

## Claims

1. An electronic circuit apparatus (1, 1b, 1d) comprising:
a dielectric substrate (10) having a first surface (11) and a second surface (12) opposite to the first surface (11),
an electronic component (61, 62, 63, 64, 66, 67, 68, 69) mounted on the first surface (11);
a heat spreader (15) bonded to the second surface (12) via a first bonding member (20); and
a conductive via (50, 50a, 50b, 50c) electrically and thermally connecting the electronic component (61, 62, 63, 64, 66, 67, 68, 69) and the heat spreader (15),
the conductive via (50, 50a, 50b, 50c) extending from the first surface (11) to at least an interior of the heat spreader (15) and being in surface-contact with the heat spreader(15).

2. The electronic circuit apparatus (1, 1b, 1d) according to claim 1, wherein the conductive via (50, 50b) penetrates the heat spreader (15).

3. The electronic circuit apparatus (1, 1b, 1d) according to claim 1 or 2, wherein:
the first bonding member (20) includes a reinforced plastic material;
the electronic component (61, 62, 63, 64, 66, 67, 68, 69) is mounted on the first surface (11) using a third bonding member (65); and
the first bonding member (20) has a softening temperature higher than a melting point of the third bonding member (65).

4. The electronic circuit apparatus (1b) according to any one of claims 1 to 3, wherein:
the conductive via (50b, 50c) includes a filling member (53); and
the filling member (53) has a thermal conductivity equal to or greater than a thermal conductivity of the dielectric substrate (10).

5. The electronic circuit apparatus (1b) according to claim 4, further comprising a cover part (55) covering a surface of the filling member (53) on a side of the heat spreader (15).

6. The electronic circuit apparatus (1, 1b, 1d) according to any one of claims 1 to 5, further comprising a semiconductor chip (70, 75) electrically connected to the electronic component (61, 62, 63, 64, 66, 67, 68, 69), wherein:
the dielectric substrate (10) has a cavity portion (13, 14) extending from the first surface (11) to the heat spreader (15); and
the semiconductor chip (70, 75) is bonded to the heat spreader (15) via a second bonding member (71) in the cavity portion (13, 14).

7. The electronic circuit apparatus (1, 1b, 1d) according to claim 6, further comprising a sealing member (80) sealing the semiconductor chip (70, 75).

8. The electronic circuit apparatus (1d) according to claim 7, further comprising a connection terminal (90) electrically connected to the electronic component (61, 62, 63, 64, 66, 67, 68, 69), wherein
a first height of the connection terminal (90) from the first surface (11) is larger than a second height of the electronic component (61, 62, 63, 64, 66, 67, 68, 69) from the first surface (11) and a third height of the sealing member (80) from the first surface (11)
